# DEMANDE DE BREVET EUROPEEN

(11) **EP 3 975 677 A1**
(43) Date de publication de la demande: **30.03.2022**
(21) Numéro de dépôt: 21199660.8
(22) Date de dépôt: 29.09.2021
(51) Int. Cl.: H05K 7/20

(54) **MODULE DE PUISSANCE ÉLECTRIQUE AVEC SYSTÈME DE REFROIDISSEMENT**

(30) Priorité: 29.09.2020 FR 2009878
(71) Demandeur: Calyos, 6040 Jumet (BE); ALSTOM Transport Technologies, 93400 Saint-Ouen-sur-Seine (FR)
(72) Inventeur: VALLE, Gilles, 65430 Soues (FR); DUPONT, Vincent, 1160 Auderghem (BE); JALBY, Philippe, 65310 Laloubere (FR); NICOLAU, Sébastien, 65100 Loubajac (FR)
(74) Mandataire: Lavoix

(57) **Abrégé**

L'invention concerne un module de puissance électrique (12) pour un véhicule ferroviaire, comportant : un dispositif (20) de conversion de courant électrique ; un circuit (28) fermé de fluide caloporteur (30) diphasique ; un premier échangeur thermique (25) apte à transférer de la chaleur dudit fluide caloporteur vers un flux d'air ; et un deuxième échangeur thermique (26) apte à transférer de la chaleur du dispositif émetteur de chaleur vers le fluide caloporteur.

Le circuit de fluide caloporteur comporte une boucle principale (32) et une branche secondaire (34), une entrée (40) et une sortie (42) de la branche secondaire étant connectées à la boucle principale à l'écart du premier échangeur, ladite entrée étant disposée en aval de ladite sortie, le deuxième échangeur thermique (26) étant disposé sur ladite branche secondaire.

## Description

La présente invention concerne un module de puissance électrique pour un véhicule, notamment un véhicule ferroviaire, du type comportant : un dispositif émetteur de chaleur, propre à participer à une conversion de courant électrique ; un circuit fermé de fluide caloporteur diphasique ; un premier échangeur thermique apte à transférer de la chaleur dudit fluide caloporteur vers un flux d'air ; et un deuxième échangeur thermique apte à transférer de la chaleur du dispositif émetteur de chaleur vers le fluide caloporteur.

Un tel module de puissance électrique avec système de refroidissement est notamment décrit dans le document EP2291067. Le système de refroidissement comporte notamment un réservoir de fluide caloporteur diphasique muni de moyens pilotés de chauffage et de refroidissement, pour alimenter le deuxième échangeur thermique.

Un tel dispositif permet de réguler un débit de pompage du fluide caloporteur dans le circuit pour modifier les performances du système de refroidissement en fonction de la chaleur dégagée par le module de puissance.

Dans un tel module de puissance, la mise en circulation du fluide caloporteur dans le circuit est notamment assurée par une vaporisation dudit fluide dans le deuxième échangeur thermique. Cependant, la température d'amorçage de la pompe avoisine les 80°C, ce qui peut être trop élevé pour les composants électroniques du module de puissance.

Par ailleurs, un tel système de refroidissement nécessite l'utilisation d'un fluide caloporteur ayant une chaleur latente élevée. Cette contrainte conduit à mettre en œuvre des fluides toxiques, comme le méthanol.

La présente invention a pour but de modifier le système de refroidissement afin de remédier à ces inconvénients, sans dégrader les performances du système.

A cet effet, l'invention a pour objet un module de puissance électrique du type précité, dans lequel : le circuit de fluide caloporteur comporte une boucle principale et une branche secondaire, la boucle principale comprenant une première et une deuxième portions reliées l'une à l'autre, le premier échangeur thermique étant disposé sur ladite première portion ; une entrée et une sortie de la branche secondaire sont connectées à la deuxième portion de la boucle principale, ladite entrée étant disposée en aval de ladite sortie sur ladite deuxième portion, selon un sens de circulation du fluide caloporteur dans la boucle principale ; et le deuxième échangeur thermique est disposé sur ladite branche secondaire.

Suivant d'autres aspects avantageux de l'invention, le module de puissance électrique comporte l'une ou plusieurs des caractéristiques suivantes, prises isolément ou suivant toutes les combinaisons techniquement possibles :
- le deuxième échangeur thermique comprend au moins un évaporateur capillaire traversé par le fluide caloporteur diphasique, ledit fluide caloporteur circulant dans le circuit fermé sous l'effet d'une pression générée au niveau d'une interface liquide/vapeur dans le ou chaque évaporateur capillaire ;
- le ou chaque évaporateur capillaire comprend une mèche capillaire, propre à assurer une vaporisation complète du fluide caloporteur reçu à l'état liquide depuis une entrée du deuxième échangeur thermique, et à renvoyer ledit fluide caloporteur en totalité à l'état gazeux vers une sortie dudit deuxième échangeur thermique ;
- le circuit fermé est une boucle à pompage capillaire, dépourvue de pompe mécanique de mise en circulation du fluide caloporteur ;
- le deuxième échangeur thermique est disposé sur un plan incliné, une entrée dudit deuxième échangeur thermique étant disposée plus haute qu'une sortie dudit deuxième échangeur thermique ;
- l'entrée du deuxième échangeur thermique est située plus bas que l'entrée de la branche secondaire ;
- le fluide caloporteur est un composé non fluoré, de préférence de l'acétone ;
- la première portion de la boucle principale est reliée à une pluralité de deuxièmes portions au moyen d'un répartiteur et d'un collecteur, disposés à chaque extrémité de ladite première portion ; le circuit de fluide caloporteur comporte une pluralité de branches secondaires, chacune desdites branches étant connectée à l'une desdites deuxièmes portions ; et le module de puissance comporte une pluralité de deuxièmes échangeurs thermiques, chacun desdits échangeurs étant disposé sur l'une desdites branches secondaires.

L'invention se rapporte en outre à un coffre de traction comportant un module de puissance électrique tel que décrit ci-dessus.

L'invention se rapporte en outre à un véhicule ferroviaire comportant une chaîne de traction comprenant un moteur électrique et un coffre de traction tel que décrit ci-dessus, ledit coffre de traction étant préférentiellement situé en toiture dudit véhicule.

L'invention sera mieux comprise à la lecture de la description qui va suivre, donnée uniquement à titre d'exemple non limitatif et faite en se référant aux dessins sur lesquels :
- [Fig 1] la figure 1 est une vue schématique partielle, de face, en coupe, d'un véhicule ferroviaire comprenant un module de puissance électrique selon un mode de réalisation de l'invention, équipé d'un dispositif de refroidissement ;
- [Fig 2] la figure 2 est une vue schématique du dispositif de refroidissement de la figure 1 ; et
- [Fig 3] la figure 3 est une vue schématique, de dessus, du dispositif de refroidissement des figures 1 et 2.

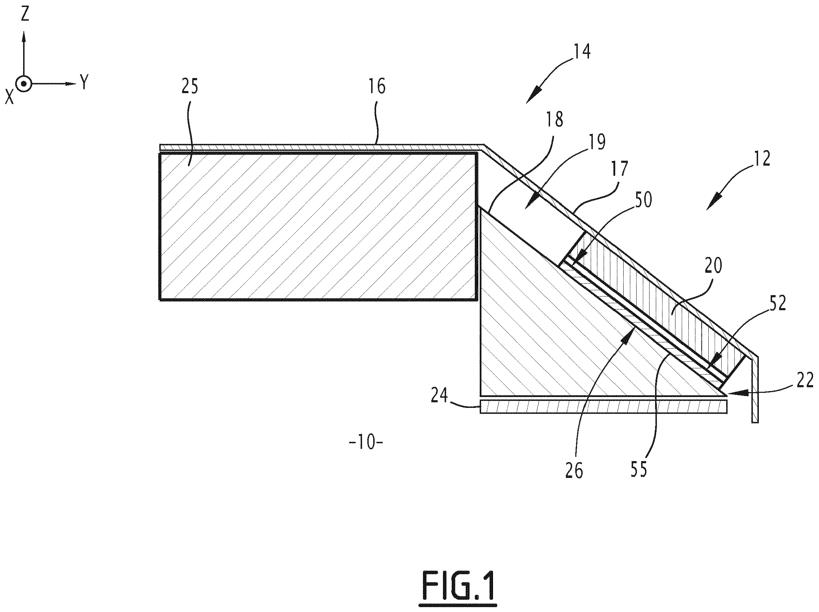

La figure 1 représente un véhicule ferroviaire 10 comprenant un module de puissance 12, ou convertisseur de puissance électrique. Le véhicule ferroviaire 10 est par exemple un véhicule moteur d'une rame de transport de passagers ou de fret. Le véhicule ferroviaire 10 comporte notamment un moteur électrique (non représenté) d'une chaîne de traction, alimenté en énergie électrique par le module de puissance 12.

Le véhicule ferroviaire 10 comporte notamment un coffre de traction 14, situé en toiture dudit véhicule et visible sur la figure 1.

On considère une base orthonormée (X, Y, Z), la direction Z représentant la verticale, la direction X correspondant à une direction longitudinale de déplacement du véhicule ferroviaire 10 et la direction Y correspondant à une direction transversale horizontale.

Une surface extérieure du coffre de traction 14 est définie par un panneau central 16, sensiblement disposé dans un plan (X, Y) et par des panneaux latéraux 17, situés de part et d'autre du panneau central 16. Les panneaux latéraux 17 sont sensiblement symétriques l'un de l'autre par rapport à un plan (X, Z) médian du véhicule ferroviaire 10. Un seul des panneaux latéraux 17 est visible sur la figure 1.

Chaque panneau latéral 17 est incliné, une extrémité en contact avec le panneau central 16 étant plus haute qu'une extrémité opposée. Il en résulte une forme convexe classique du coffre de traction 14. A titre indicatif, un panneau latéral est incliné d'un angle compris entre 20° et 60° par rapport à l'horizontale.

Par ailleurs, le coffre de traction 14 comprend une structure interne comportant au moins un plan incliné 18, sensiblement parallèle à un panneau latéral 17 et disposé sous ledit panneau latéral. Un espace situé entre ledit panneau latéral 17 et ledit plan incliné 18 forme un compartiment interne 19 du coffre de traction 14.

Le module de puissance 12 comporte au moins une unité de conversion 20, apte à émettre de la chaleur, et un dispositif 22 de refroidissement de l'au moins une unité 20. De préférence, le module de puissance 12 comporte une pluralité d'unités de conversion 20 sensiblement identiques, le dispositif 22 de refroidissement étant apte à refroidir chacune desdites unités.

De préférence, le module de puissance 12 comporte en outre au moins une capacité filtre 24, électriquement reliée à l'unité ou aux unités de conversion 20.

L'unité de conversion 20 comporte notamment une pluralité de dispositifs semi-conducteurs de type transistor, reliés par un dispositif de connexion. Préférentiellement, les dispositifs semi-conducteurs sont des transistors bipolaires à grille isolée (IGBT). Les IGBT ont notamment une fonction de commutateurs dans l'unité de conversion 20.

L'unité de conversion 20 ou au moins une unité de conversion 20 est de préférence disposée dans le compartiment interne 19 du coffre de traction 14.

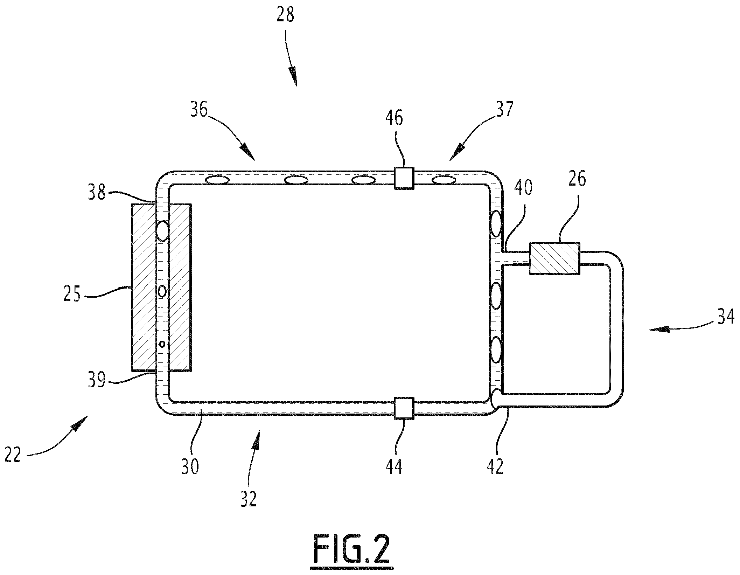

Le dispositif 22 de refroidissement, schématisé sur la figure 2, comporte un premier 25 et au moins un deuxième 26 échangeurs thermiques ; et un circuit fluidique 28 fermé, reliant lesdits premier 25 et deuxième 26 échangeurs. Un fluide caloporteur 30 diphasique circule dans ledit circuit fluidique 28.

Préférentiellement, le fluide caloporteur 30 est un composé non fluoré, plus préférentiellement de l'acétone. Le méthanol peut également être utilisé. Le gaz R-1233zd(E) et le gaz R-1336mzz(Z), qui sont des gaz fluorés de la famille des hydrofluoro-oléfines (HFO), peuvent également être utilisés.

Le premier échangeur thermique 25 est apte à effectuer un échange thermique entre le fluide caloporteur 30 du circuit fluidique 28 et l'air extérieur, notamment un flux d'air généré par un déplacement du véhicule ferroviaire 10. On parle alors de convection mixte. En variante, l'échange thermique entre le fluide caloporteur 30 du circuit fluidique 28 et l'air extérieur est réalisé par convection naturelle (par un phénomène de gradient) ou par convention forcée (par circulation artificielle du fluide).

Le premier échangeur thermique 25 est par exemple un radiateur à ailettes. Ledit premier échangeur thermique est préférentiellement disposé au milieu du coffre de traction 14 selon la direction transversale Y, c'est-à-dire sous le panneau central 16.

Le deuxième échangeur thermique 26 est apte à effectuer un échange thermique entre l'unité de conversion 20 et le fluide caloporteur 30 du circuit fluidique 28. A cet effet, le deuxième échangeur thermique 26 est disposé en contact thermique avec l'unité de conversion 20. De préférence, les IGBT de ladite unité de conversion sont en contact thermique avec le deuxième échangeur thermique 26.

Un contact thermique efficace entre les IGBT et le deuxième échangeur thermique 26 est par exemple réalisé au moyen d'une interface thermique du type interface sèche, notamment réalisée en graphite.

Le deuxième échangeur thermique 26 est préférentiellement disposé dans le compartiment interne 19 du coffre de traction 14, par exemple contre le plan incliné 18. Une structure préférée du deuxième échangeur thermique 26 sera précisée ci-après.

Le circuit fluidique 28 comporte notamment une boucle principale 32 et une branche secondaire 34. La boucle principale 32 comporte une première 36 et une deuxième 37 portions reliées l'une à l'autre.

Le premier échangeur thermique 25 est disposé sur la première portion 36 de la boucle principale 32 et comporte une entrée 38 et une sortie 39. De préférence, la sortie 39 est située plus bas que l'entrée 38 par rapport à la verticale.

La branche secondaire 34 est connectée à la deuxième portion 37 de la boucle principale 32, ladite deuxième portion étant également nommée injecteur. Plus précisément, une entrée 40 et une sortie 42 de la branche secondaire sont connectées à l'injecteur 37, ladite entrée 40 étant disposée en aval de ladite sortie 42 selon un sens de circulation du fluide caloporteur dans la boucle principale 32.

Le deuxième échangeur thermique 26 est disposé sur la branche secondaire 34.

Préférentiellement, la sortie 42 de la branche secondaire 34 est située plus bas que l'entrée 40 par rapport à la verticale. Préférentiellement, l'entrée 40 de la branche secondaire 34 est située plus bas que le collecteur 46 et/ou que l'entrée 38 du premier échangeur thermique 25 par rapport à la verticale.

Préférentiellement, la première portion 36 de la boucle principale 32 est reliée à l'injecteur 37 au moyen d'un répartiteur 44 et d'un collecteur 46, disposés à chaque extrémité de ladite première portion 36. Plus préférentiellement, le circuit fluidique 28 comporte une pluralité d'injecteurs 37 reliés à la première portion 36 au moyen du répartiteur 44 et du collecteur 46 ; et une pluralité de branches secondaires 34, chacune desdites branches secondaires étant connectée à un injecteur 37 ; et le dispositif 22 de refroidissement comporte une pluralité de deuxièmes échangeurs thermiques 26, chacun desdits échangeurs étant disposé sur l'une desdites branches secondaires 34. Chacun des deuxièmes échangeurs thermiques 26 est disposé en contact thermique avec une unité de conversion 20 du module de puissance 12.

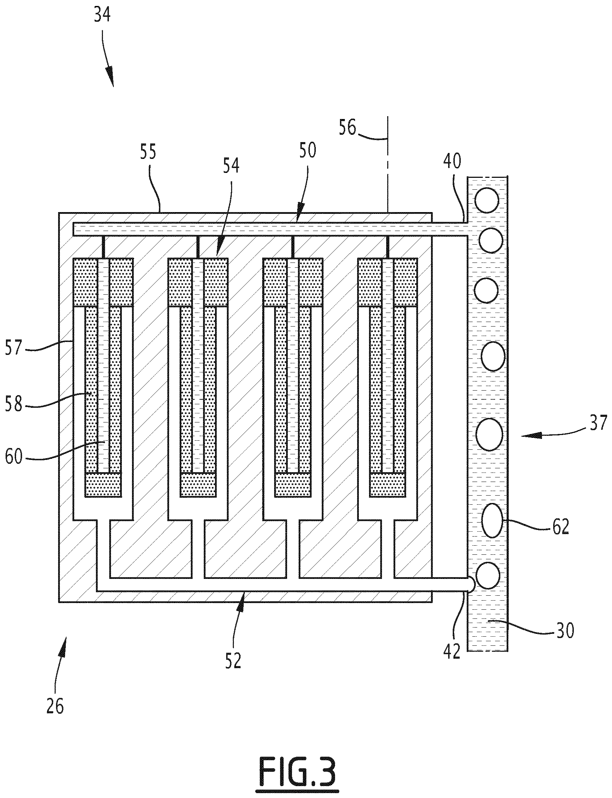

Le deuxième échangeur thermique 26, représenté plus en détails sur la figure 3, va à présent être décrit plus précisément. Dans le cas où le module de puissance 12 comporte plusieurs deuxièmes échangeurs thermiques 26, ils sont considérés comme sensiblement identiques.

Le deuxième échangeur thermique 26 comprend une entrée 50, une sortie 52 et au moins un évaporateur capillaire 54 disposé entre l'entrée 50 et la sortie 52.

De préférence, l'entrée 50 est située plus haut que la sortie 52 selon la verticale. Dans le mode de réalisation représenté sur la figure 1, le deuxième échangeur thermique 26 est notamment disposé sur le plan incliné 18.

Plus préférentiellement, l'entrée 40 de la branche secondaire 34, l'entrée 50 et la sortie 52 du deuxième échangeur thermique 26, et la sortie 42 de la branche secondaire 34 sont disposées dans cet ordre du haut vers le bas.

Dans le mode de réalisation représenté sur la figure 3, l'entrée 50 et la sortie 52 sont formées respectivement par un conduit répartiteur et par un conduit collecteur ; et le deuxième échangeur thermique 26 comprend plusieurs évaporateurs capillaires 54 disposés en parallèle. De préférence, le nombre d'évaporateurs capillaires du deuxième échangeur thermique 26 est compris entre 1 et 3.

Dans le mode de réalisation représenté sur la figure 3, le deuxième échangeur thermique 26 comprend également une enveloppe externe 55 supportant les évaporateurs capillaires 54.

Chaque évaporateur capillaire 54 a une forme allongée de section carrée, s'étendant sensiblement selon un axe 56, et comporte : un châssis externe 57, une mèche capillaire 58, logée à l'intérieur dudit châssis externe, et une chambre interne 60 délimitée par la mèche capillaire 58. Dans le mode de réalisation représenté, l'axe 56 est sensiblement disposé dans un plan (Y, Z) et incliné par rapport à la verticale.

Une première extrémité axiale de la chambre interne 60 est reliée au conduit répartiteur formant l'entrée 50 du deuxième échangeur thermique 26. Une seconde extrémité axiale de ladite chambre interne, située plus bas que la première extrémité, est fermée par la mèche capillaire 58.

Une première extrémité axiale du châssis externe 57 est fermée par la mèche capillaire 58. Une seconde extrémité axiale dudit châssis, située plus bas que la première extrémité, est reliée au conduit collecteur formant la sortie 52 du deuxième échangeur thermique 26.

La mèche capillaire 58 est formée d'un matériau poreux, comprenant plus précisément des ménisques (non représentés) reliant la chambre interne 60 et le tube externe 57.

Comme il sera décrit ci-après, le ou les évaporateurs capillaires 54 sont destinés à mettre en circulation le fluide caloporteur 30 dans le circuit fluidique 28 fermé. Préférentiellement, ledit circuit fluidique 28 est par ailleurs dépourvu de pompe mécanique de mise en circulation du fluide caloporteur 30, ladite mise en circulation étant uniquement assurée par le ou lesdits évaporateurs capillaires 54.

Un fonctionnement du module de puissance 12 va à présent être décrit.

Le moteur électrique de la chaîne de traction du véhicule ferroviaire décrit ci-dessus est mis en fonctionnement, pour le déplacement dudit véhicule ferroviaire. L'au moins une unité de conversion 20 du module de puissance 12 est également mise en fonctionnement. Les composants de ladite unité de conversion, notamment les IGBT, dégagent donc de la chaleur qui diffuse par conduction à travers l'enveloppe externe 55 du deuxième échangeur thermique 26, jusqu'aux châssis externes 57 des évaporateurs capillaires 54. Les pompes formées par lesdits évaporateurs capillaires sont alors amorcées, par vaporisation de fluide caloporteur 30 au niveau desdits châssis externes. Cette auto-pressurisation permet d'abaisser la température de démarrage du thermosiphon.

Ainsi, le fluide caloporteur 30 entre dans le deuxième échangeur thermique 26 à l'état liquide au niveau de l'entrée 50, est vaporisé en traversant la mèche capillaire 58 et sort à l'état de vapeur au niveau de la sortie 52 dudit échangeur. Le fluide caloporteur 30 absorbe ainsi la chaleur émise par l'unité de conversion 20, par l'intermédiaire du deuxième échangeur thermique 26.

La vapeur ainsi formée rejoint ensuite la sortie 42 de la branche secondaire 34 du circuit fluidique 28, ladite sortie 42 étant située en partie basse dudit circuit. Dans l'injecteur 37, des bulles 62 de gaz se mélangent donc au fluide caloporteur 30 liquide circulant dans la boucle principale 32. La présence desdites bulles 62 favorise une circulation dudit fluide du bas vers le haut, en direction du collecteur 46. Par ailleurs, la chaleur véhiculée par les bulles 62 réchauffe le fluide caloporteur 30 liquide, ce qui favorise également son déplacement vers le haut.

Le fluide caloporteur 30 sous forme diphasique entre ainsi dans la première portion 36 du circuit fluidique 28, jusqu'à l'entrée 38 du premier échangeur thermique 25. Au niveau dudit premier échangeur, le fluide caloporteur 30 cède alors de la chaleur à un flux d'air, généré par exemple par un déplacement du véhicule ferroviaire. La concentration de gaz diminue dans ledit fluide caloporteur 30. En outre, la température dudit fluide s'abaisse, ce qui favorise son déplacement vers le bas, en direction de la sortie 39 du premier échangeur thermique 25.

Le fluide caloporteur 30 refroidi rejoint l'injecteur 37 au niveau du répartiteur 44, puis arrive au niveau de la sortie 42 de la branche secondaire 34 décrite précédemment, ce qui entretient le cycle de circulation dudit fluide 3 dans le circuit 28.

La boucle principale 32 du circuit fluidique 28 fonctionne ainsi selon le principe du thermosiphon, la vitesse du fluide 30 étant augmentée par l'injection des bulles 62 de gaz en sortie 42 de la branche secondaire 34.

Par rapport aux systèmes de pompage capillaire connus, comme celui décrit dans le document EP2291067, cette augmentation de la vitesse de fluide permet d'utiliser des fluides caloporteurs présentant une chaleur latente plus faible, sans dégrader les performances du dispositif de refroidissement. Il est ainsi possible d'utiliser des fluides du type acétone, moins toxique que le méthanol, en tant que fluide caloporteur 30.

Au niveau de l'entrée 40 de la branche secondaire 34, une première partie du fluide 30 reste dans l'injecteur 37 et une seconde partie dudit fluide se déplace en direction du deuxième échangeur thermique 26. Du fait de sa position inclinée, les bulles 62 de gaz tendent à ne pas pénétrer dans ledit deuxième échangeur thermique 26. Le fluide caloporteur 30 entre ainsi à l'état liquide dans la chambre interne 60 de chaque évaporateur capillaire 54, avant d'être vaporisé dans la mèche capillaire 58.

Contrairement au cas des évaporateurs capillaires décrits dans le document EP2291067, la température de vaporisation du fluide caloporteur 30 dans la mèche capillaire 58 n'est pas constante ; ladite température peut varier au sein d'une plage dépendant des conditions d'échange thermique dans le premier échangeur 25.

Un tel dispositif permet de supprimer le réservoir de fluide décrit dans le document EP2291067, ainsi que le pilotage des moyens de contrôle thermique dudit réservoir.

## Revendications

1. Module (12) de puissance électrique pour un véhicule (10), notamment un véhicule ferroviaire, comportant :
- un dispositif (20) émetteur de chaleur, propre à participer à une conversion de courant électrique ;
- un circuit (28) fermé de fluide caloporteur (30) diphasique ;
- un premier échangeur thermique (25) apte à transférer de la chaleur dudit fluide caloporteur vers un flux d'air ; et
- un deuxième échangeur thermique (26) apte à transférer de la chaleur du dispositif émetteur de chaleur vers le fluide caloporteur ;
**caractérisé en ce que** le circuit (28) de fluide caloporteur (30) comporte une boucle principale (32) et une branche secondaire (34), la boucle principale comprenant une première (36) et une deuxième (37) portions reliées l'une à l'autre, le premier échangeur thermique (25) étant disposé sur ladite première portion,
une entrée (40) et une sortie (42) de la branche secondaire étant connectées à la deuxième portion de la boucle principale, ladite entrée étant disposée en aval de ladite sortie sur ladite deuxième portion, selon un sens de circulation du fluide caloporteur dans la boucle principale,
le deuxième échangeur thermique (26) étant disposé sur ladite branche secondaire.

2. Module (12) de puissance selon la revendication 1, dans lequel le deuxième échangeur thermique (26) comprend au moins un évaporateur capillaire (54) traversé par le fluide caloporteur (30) diphasique, ledit fluide caloporteur circulant dans le circuit fermé sous l'effet d'une pression générée au niveau d'une interface liquide/vapeur dans le ou chaque évaporateur capillaire.

3. Module (12) de puissance selon la revendication 2, dans lequel le ou chaque évaporateur capillaire (54) comprend une mèche capillaire (58), propre à assurer une vaporisation complète du fluide caloporteur (30) reçu à l'état liquide depuis une entrée (50) du deuxième échangeur thermique, et à renvoyer ledit fluide caloporteur en totalité à l'état gazeux vers une sortie (52) dudit deuxième échangeur thermique.

4. Module (12) de puissance selon l'une des revendications 2 à 3, dans lequel le circuit fermé (28) est une boucle à pompage capillaire, dépourvue de pompe mécanique de mise en circulation du fluide caloporteur.

5. Module (12) de puissance selon l'une des revendications 2 à 4, dans lequel le deuxième échangeur thermique (26) est disposé sur un plan incliné, une entrée (50) dudit deuxième échangeur thermique étant disposée plus haute qu'une sortie (52) dudit deuxième échangeur thermique.

6. Module (12) de puissance selon la revendication 5, dans lequel l'entrée (50) du deuxième échangeur thermique (26) est située plus bas que l'entrée (40) de la branche secondaire (34).

7. Module (12) de puissance selon l'une des revendications précédentes, dans lequel le fluide caloporteur (30) est un composé non fluoré, de préférence de l'acétone.

8. Module (12) de puissance selon l'une des revendications précédentes, dans lequel : la première portion (36) de la boucle principale (32) est reliée à une pluralité de deuxièmes portions (37) au moyen d'un répartiteur (44) et d'un collecteur (46), disposés à chaque extrémité de ladite première portion ; le circuit (28) de fluide caloporteur comporte une pluralité de branches secondaires (34), chacune desdites branches étant connectée à l'une desdites deuxièmes portions (37) ; et le module de puissance comporte une pluralité de deuxièmes échangeurs thermiques (26), chacun desdits échangeurs étant disposé sur l'une desdites branches secondaires (34).

9. Coffre de traction (14) pour véhicule ferroviaire, comportant un module de puissance électrique (12) selon l'une quelconque des revendications précédentes.

10. Véhicule ferroviaire (10) comportant une chaîne de traction comprenant un moteur électrique et un coffre de traction (14) selon la revendication 9, ledit coffre de traction étant préférentiellement situé en toiture dudit véhicule.
